# EUROPÄISCHE PATENTANMELDUNG

(11) **EP 4 679 714 A1**
(43) Veröffentlichungstag der Anmeldung: **14.01.2026**
(21) Anmeldenummer: 24187103.7
(22) Anmeldetag: 08.07.2024
(51) Int. Cl.: H03K 17/12, H03K 17/687, H03K 17/693

(54) **SCHALTANORDNUNG MIT VERSCHIEDENEN HALBLEITERSCHALTERN**

(71) Anmelder: Siemens Aktiengesellschaft, 80333 München (DE)
(72) Erfinder: Nährig, Matthias, 91334 Hemhofen (DE)
(74) Vertreter: Siemens Patent Attorneys

(57) **Zusammenfassung**

Die Erfindung betrifft eine Schaltanordnung (1), die wenigstens eine Schalterparallelschaltung (3, 4), die einen ersten Stromzweig (5) mit wenigstens einem ersten Halbleiterschalter (T1) und einen zu dem ersten Stromzweig (5) parallel geschalteten zweiten Stromzweig (7) mit wenigstens einem zweiten Halbleiterschalter (T2) aufweist, und eine Steuereinheit (9), die zum Ansteuern jedes ersten und jedes zweiten Halbleiterschalters (T2) eingerichtet ist, umfasst. Jeder erste Halbleiterschalter (T1) weist geringere Schaltverluste und eine höhere Schaltgeschwindigkeit als jeder zweite Halbleiterschalter (T2) auf und jeder zweite Halbleiterschalter (T2) weist in Durchlassrichtung zumindest oberhalb eines Schwellenwertes (Is) für die elektrische Stromstärke eine höhere elektrische Leitfähigkeit als jeder erste Halbleiterschalter (T1) in Durchlassrichtung auf.

## Beschreibung

Die Erfindung betrifft eine Schaltanordnung mit verschiedenen Halbleiterschaltern.

Halbleiterschalter werden in vielen Schaltanordnungen verwendet. Dabei hängt die Auswahl von in einer Schaltanordnung verwendeten Halbleiterschaltern von dem Zweck ab, dem die Schaltanordnung dient. Halbleiterschalter unterscheiden sich voneinander insbesondere hinsichtlich ihrer Schaltverluste und ihrer Leitverluste. Die Schaltverluste und Leitverluste eines Halbleiterschalters werden durch dessen Zelldesign, den Halbleitertyp und das Halbleitermaterial beeinflusst. Geringere Schaltverluste bedingen höhere Leitverluste und umgekehrt. Halbleiterschalter mit geringen Schaltverlusten werden insbesondere eingesetzt, wenn hohe Schaltgeschwindigkeiten und Schaltfrequenzen der Halbleiterschalter gefordert werden. Halbleiterschalter mit geringen Leitverlusten werden insbesondere eingesetzt, wenn längere Einschaltdauern der Halbleiterschalter gefordert werden. Daneben gibt es Halbleiterschalter mit einem ausgeglichenen Verhältnis von Schaltverlusten und Leitverlusten, um einen Kompromiss zwischen Schaltverlusten und Leitverlusten zu erreichen.

Der Erfindung liegt die Aufgabe zugrunde, eine Schaltanordnung mit Halbleiterschaltern anzugeben, die sowohl geringe Schaltverluste als auch geringe Leitverluste aufweist.

Die Aufgabe wird erfindungsgemäß durch eine Schaltanordnung mit den Merkmalen des Anspruchs 1 und ein Verfahren mit den Merkmalen des Anspruchs 10 gelöst.

Vorteilhafte Ausgestaltungen der Erfindung sind Gegenstand der Unteransprüche.

Eine erfindungsgemäße Schaltanordnung umfasst
- wenigstens eine Schalterparallelschaltung, die einen ersten Stromzweig mit wenigstens einem ersten Halbleiterschalter und einen zu dem ersten Stromzweig parallel geschalteten zweiten Stromzweig mit wenigstens einem zweiten Halbleiterschalter aufweist, und
- eine Steuereinheit, die zum Ansteuern jedes ersten und jedes zweiten Halbleiterschalters eingerichtet ist, wobei
- jeder erste Halbleiterschalter geringere Schaltverluste und eine höhere Schaltgeschwindigkeit als jeder zweite Halbleiterschalter aufweist und
- jeder zweite Halbleiterschalter in Durchlassrichtung zumindest oberhalb eines Schwellenwertes für die elektrische Stromstärke eine höhere elektrische Leitfähigkeit als jeder erste Halbleiterschalter in Durchlassrichtung aufweist.

Durch die Schalterparallelschaltung zweier Halbleiterschalter, die sich voneinander durch ihre Schaltverluste und ihre Leitverluste unterscheiden, können die Vorteile eines ersten Halbleiterschalters mit geringen Schaltverlusten und eines zweiten Halbleiterschalters, der oberhalb eines Schwellenwertes für die elektrische Stromstärke geringere Leitverluste als der erste Halbleiterschalter aufweist, kombiniert werden. Beim Einschalten der Schalterparallelschaltung wird zuerst der erste Halbleiterschalter mit geringen Schaltverlusten eingeschaltet. Der Strom wird also zunächst von dem ersten Halbleiterschalter geleitet. Nach dem Einschalten des zweiten Halbleiterschalters geht die Leitung eines Hauptanteils des Stroms jedoch schnell auf den zweiten Halbleiterschalter über, da dieser oberhalb des Schwellenwertes für die Stromstärke besser als der erste Halbleiterschalter leitet. Da der zweite Halbleiterschalter nach dem Einschalten des ersten Halbleiterschalters geschaltet wird, erfolgt das Einschalten des zweiten Halbleiterschalter nahezu spannungslos, so dass auch für das Einschalten des zweiten Halbleiterschalters nur geringe Schaltverluste anfallen.

Bei einer Ausgestaltung der erfindungsgemäßen Schaltanordnung ist jeder erste Halbleiterschalter ein Siliziumkarbit-MOSFET, ein Galliumnitrid-MOSFET (MOSFET: Abkürzung für Metal-Oxide-Semiconductor Field-Effect Transistor, deutsch: Metall-Oxid-Halbleiter-Feldeffekttransistor) oder ein IGBT (Abkürzung für Insulated-Gate Bipolar Transistor, deutsch: Bipolartransistor mit isolierter Gate-Elektrode).

Siliziumkarbit-MOSFETs und Galliumnitrid-MOSFETs weisen besonders geringe Schaltverluste auf und eignen sich daher besonders gut als erste Halbleiterschalter einer erfindungsgemäßen Schaltanordnung. IGBTs sind vergleichsweise kostengünstig.

Bei einer weiteren Ausgestaltung der erfindungsgemäßen Schaltanordnung ist jeder zweite Halbleiterschalter ein IGBT.

IGBTs weisen oberhalb eines Schwellenwertes für die Stromstärke geringere Leitverluste als beispielsweise MOSFETs auf und eignen sich daher als zweite Halbleiterschalter einer erfindungsgemäßen Schaltanordnung. Wenn der erste Halbleiterschalter der Schaltanordnung ebenfalls ein IGBT ist, werden unterschiedlich ausgebildete IGBTs als erster und zweiter Halbleiterschalter verwendet.

Bei einer weiteren Ausgestaltung der erfindungsgemäßen Schaltanordnung weist der erste Stromzweig wenigstens einer Schalterparallelschaltung mehrere, insbesondere zwei, in Reihe geschaltete erste Halbleiterschalter auf und von der Reihenschaltung zweigt zwischen je zwei aufeinander folgenden ersten Halbleiterschaltern ein erster Zwischenabgriff ab, über den ein Strompfad aus der Reihenschaltung herausführbar ist.

Bei einer weiteren Ausgestaltung der erfindungsgemäßen Schaltanordnung ist die Steuereinheit eingerichtet, den Strompfad aus einer Reihenschaltung mehrerer erster Halbleiterschalter einer Schalterparallelschaltung über einen ersten Zwischenabgriff in Abhängigkeit von einer geforderten Ausgangsspannung der Schalterparallelschaltung herauszuführen.

Die vorgenannten Ausgestaltungen der erfindungsgemäßen Schaltanordnung ermöglichen, wenigstens eine Schalterparallelschaltung wahlweise mit einem oder mehreren ersten Halbleiterschaltern zu betreiben.

Eine weitere Ausgestaltung der erfindungsgemäßen Schaltanordnung weist mehrere in Reihe geschaltete Schalterparallelschaltungen auf, wobei von der Reihenschaltung zwischen je zwei aufeinander folgenden Schalterparallelschaltungen ein zweiter Zwischenabgriff abzweigt, über den ein Strompfad aus der Reihenschaltung herausführbar ist.

Bei einer weiteren Ausgestaltung der erfindungsgemäßen Schaltanordnung ist die Steuereinheit eingerichtet, eine geforderte Ausgangsspannung der Schaltanordnung durch Halbleiterschalter einer von der Ausgangsspannung abhängigen Anzahl in Reihe geschalteter Schalterparallelschaltungen zu realisieren und dabei die Spannung wenigstens eines ersten Halbleiterschalters einer dieser Schalterparallelschaltungen zu modulieren, beispielsweise durch eine pulsweitenmodulierte Ansteuerung des ersten Halbleiterschalters.

Die vorgenannten Ausgestaltungen der erfindungsgemäßen Schaltanordnung ermöglichen, höhere Spannungen durch mehrere Schalterparallelschaltungen als durch nur eine Schalterparallelschaltung zu erzeugen. Ferner können beispielsweise zeitabhängige Ausgangsspannungen der Schaltanordnung realisiert werden, indem eine Anzahl verwendeter Schalterparallelschaltungen in Abhängigkeit von der Zeit verändert wird. Durch eine Modulation, insbesondere durch eine Pulsweitenmodulation, der Spannung wenigstens eines ersten Halbleiterschalters einer dieser Schalterparallelschaltungen kann die Ausgangsspannung als Mittelwert der Modulation ferner praktisch kontinuierlich verändert werden.

Das erfindungsgemäße Verfahren dient dem Betreiben einer erfindungsgemäßen Schaltanordnung mit mehreren in Reihe geschalteten Schalterparallelschaltungen. Dabei wird eine geforderte Ausgangsspannung der Schaltanordnung durch Halbleiterschalter einer von der Ausgangsspannung abhängigen Anzahl in Reihe geschalteter Schalterparallelschaltungen realisiert, wobei die Spannung wenigstens eines ersten Halbleiterschalters einer dieser Schalterparallelschaltungen moduliert wird, beispielsweise durch eine pulsweitenmodulierte Ansteuerung des ersten Halbleiterschalters.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 Ausgangskennlinien zweier Halbleiterschalter,
FIG 2 einen Schaltplan eines ersten Ausführungsbeispiels einer erfindungsgemäßen Schaltanordnung,
FIG 3 einen Schaltplan eines zweiten Ausführungsbeispiels einer erfindungsgemäßen Schaltanordnung,
FIG 4 Ströme, Spannungen und Ansteuersignale einer erfindungsgemäßen Schaltanordnung in Abhängigkeit von einer Zeit,
FIG 5 einen Schaltplan eines dritten Ausführungsbeispiels einer erfindungsgemäßen Schaltanordnung,
FIG 6 einen Schaltplan eines vierten Ausführungsbeispiels einer erfindungsgemäßen Schaltanordnung,
FIG 7 einen Schaltplan eines fünften Ausführungsbeispiels einer erfindungsgemäßen Schaltanordnung,
FIG 8 ein Spannungs-Zeit-Diagramm einer mit einer erfindungsgemäßen Schaltanordnung zu realisierenden Spannung,
FIG 9 eine erste Realisierung der in Figur 8 gezeigten Spannung mit einer erfindungsgemäßen Schaltanordnung,
FIG 10 eine zweite Realisierung der in Figur 8 gezeigten Spannung mit einer erfindungsgemä-ßen Schaltanordnung.

Einander entsprechende Teile sind in den Figuren mit denselben Bezugszeichen versehen.

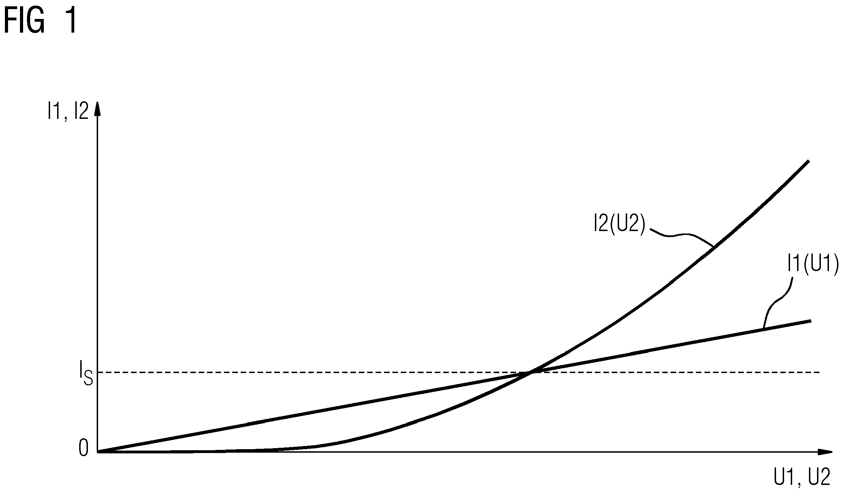

Figur 1 (FIG 1) zeigt Ausgangskennlinien I1(U1), I2(U2) zweier Halbleiterschalter in deren Durchlassrichtungen bei kleinen Spannungen U1, U2. I1(U1) zeigt die Stromstärke 11 eines in einem ersten Halbleiterschalter fließenden Stroms in Abhängigkeit von einer an dem ersten Halbleiterschalter anliegenden Spannung U1. Beispielsweise ist der erste Halbleiterschalter ein MOSFET. Dann ist 11 die Stromstärke eines durch einen Drain-Anschluss des MOSFET fließenden Drain-Stroms und U1 ist eine zwischen dem Drain-Anschluss und dem Source-Anschluss des MOSFET anliegende Drain-Source-Spannung. I2(U2) zeigt die Stromstärke I2 eines in einem zweiten Halbleiterschalter fließenden Stroms in Abhängigkeit von einer an dem zweiten Halbleiterschalter anliegenden Spannung U2. Beispielsweise ist der zweite Halbleiterschalter ein IGBT. Dann ist I2 die Stromstärke eines durch einen Kollektor-Anschluss des MOSFET fließenden Kollektor-Stroms und U2 ist eine zwischen dem Kollektor-Anschluss und dem Emitter-Anschluss des MOSFET anliegende Kollektor-Emitter-Spannung.

Die Stromstärke I1 des ersten Halbleiterschalters steigt bei kleinen Spannungen U1 im Wesentlichen linear mit der Spannung U1 an, während die Stromstärke I2 des zweiten Halbleiterschalters bei kleinen Spannungen U2 im Wesentlichen quadratisch mit der Spannung U2 ansteigt. Bis zu einem Schwellenwert I_{S} für die Stromstärken I1, I2 weist der erste Halbleiterschalter eine bessere elektrische Leitfähigkeit als der zweite Halbleiterschalter auf. Oberhalb des Schwellenwerts I_{S} weist der zweite Halbleiterschalter eine bessere elektrische Leitfähigkeit als der erste Halbleiterschalter auf.

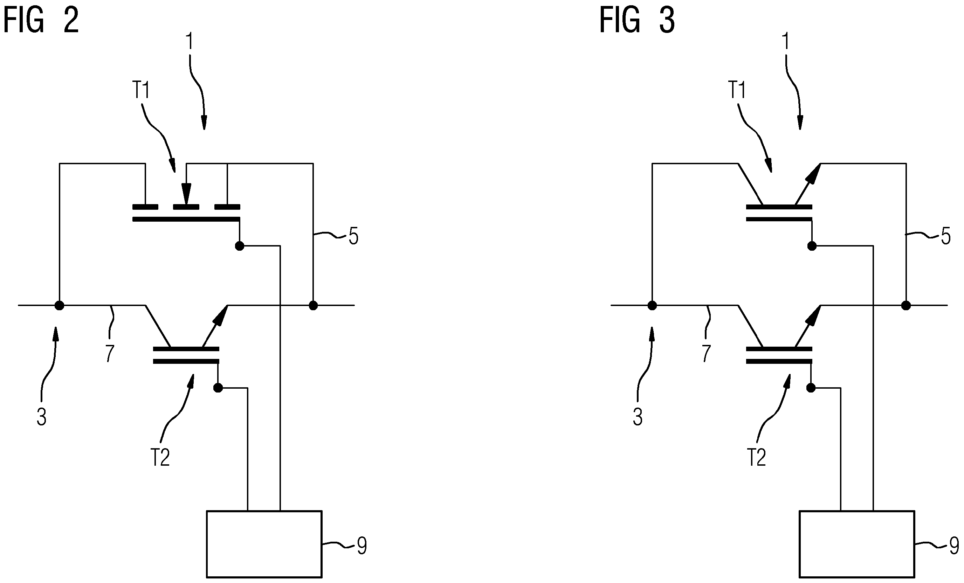

Figur 2 (FIG 2) zeigt einen Schaltplan eines ersten Ausführungsbeispiels einer erfindungsgemä-ßen Schaltanordnung 1. Die Schaltanordnung 1 umfasst eine Schalterparallelschaltung 3, die einen ersten Stromzweig 5 mit einem ersten Halbleiterschalter T1 und einen zu dem ersten Stromzweig 5 parallel geschalteten zweiten Stromzweig 7 mit einem zweiten Halbleiterschalter T2 aufweist. Ferner umfasst die Schaltanordnung 1 eine Steuereinheit 9, die zum Ansteuern des ersten Halbleiterschalters T1 und des zweiten Halbleiterschalters T2 eingerichtet ist. Der erste Halbleiterschalter T1 weist geringere Schaltverluste und eine höhere Schaltgeschwindigkeit als der zweite Halbleiterschalter T2 auf. Der zweite Halbleiterschalter T2 weist in Durchlassrichtung oberhalb eines Schwellenwertes I_{S} für die elektrische Stromstärke eine höhere elektrische Leitfähigkeit als der erste Halbleiterschalter T1 in Durchlassrichtung auf. Bei diesem Ausführungsbeispiel ist der erste Halbleiterschalter T1 ein Siliziumkarbit-MOSFET oder ein Galliumnitrid-MOSFET und der zweite Halbleiterschalter T2 ist ein IGBT.

Figur 3 (FIG 3) zeigt einen Schaltplan eines zweiten Ausführungsbeispiels einer erfindungsgemäßen Schaltanordnung 1. Dieses Ausführungsbeispiel unterscheidet sich von dem in Figur 1 gezeigten Ausführungsbeispiel lediglich dadurch, dass der erste Halbleiterschalter T1 ein IGBT ist, wobei dieser IGBT geringere Schaltverluste und eine höhere Schaltgeschwindigkeit als der zweite Halbleiterschalter T2 aufweist, der ebenfalls als ein IGBT ausgebildet ist und in Durchlassrichtung oberhalb eines Schwellenwertes I_{S} für die elektrische Stromstärke eine höhere elektrische Leitfähigkeit als der erste Halbleiterschalter T1 in Durchlassrichtung aufweist.

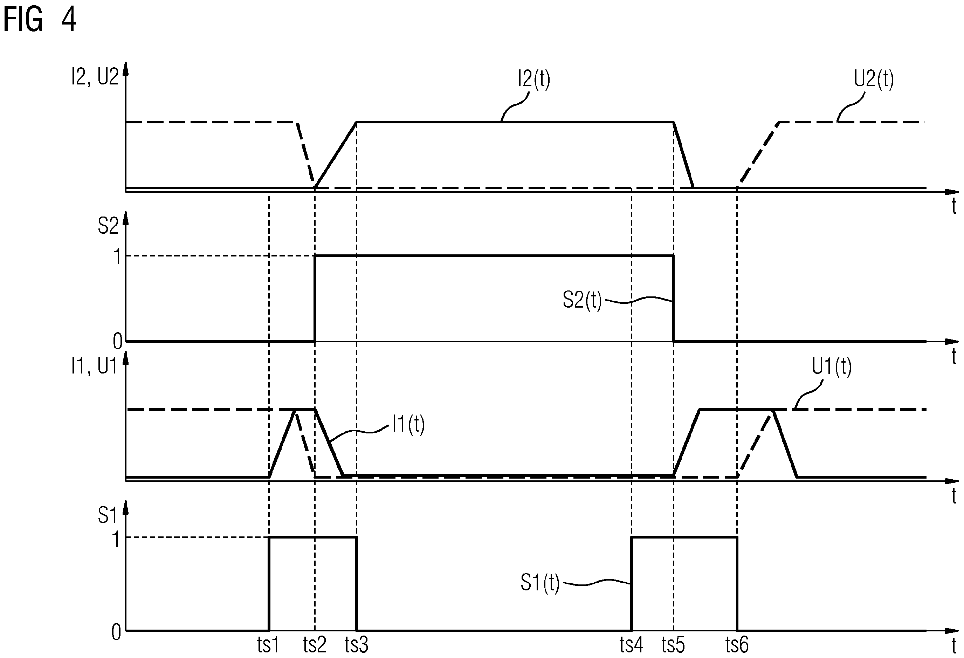

Figur 4 (FIG 4) zeigt ein Beispiel von Strömen I1, I2, Spannungen U1, U2 und Ansteuersignalen S1, S2 in Abhängigkeit von einer Zeit t für eine in Figur 1 oder Figur 2 gezeigte Schaltanordnung 1. Dabei ist I1 (t) ein zeitlicher Stromverlauf eines in dem ersten Halbleiterschalter T1 fließenden Stroms I1 und U1(t) ist ein zeitlicher Spannungsverlauf einer an dem ersten Halbleiterschalter T1 anliegenden Spannung U1. Entsprechend ist I2(t) ein zeitlicher Stromverlauf eines in dem zweiten Halbleiterschalter T2 fließenden Stroms I2 und U2(t) ist ein zeitlicher Spannungsverlauf einer an dem zweiten Halbleiterschalter T2 anliegenden Spannung U2. S1(t) ist ein zeitlicher Verlauf eines Ansteuersignals, mit dem der erste Halbleiterschalter T1 von der Steuereinheit 9 angesteuert wird. S2(t) ist ein zeitlicher Verlauf eines Ansteuersignals, mit dem der zweite Halbleiterschalter T2 von der Steuereinheit 9 angesteuert wird. Die Ansteuersignale S1, S2 nehmen (normierte) Werte S=0 und S=1 an. Für S1=0 ist der erste Halbleiterschalter T1 abgeschaltet, für S1=1 ist der erste Halbleiterschalter T1 eingeschaltet. Für S2=0 ist der zweite Halbleiterschalter T2 abgeschaltet, für S2=1 ist der zweite Halbleiterschalter T2 eingeschaltet.

Beim Einschalten der Schaltanordnung 1 wird zunächst zu einem Schaltzeitpunkt ts1 der erste Halbleiterschalter T1 eingeschaltet. Daraufhin nimmt I1 zu bis I1 einen Maximalwert erreicht. Daraufhin fallen die Spannungen U1 und U2 (fast) auf Null. Danach wird zu einem Schaltzeitpunkt ts2 der zweite Halbleiterschalter T2 eingeschaltet, das heißt der zweite Halbleiterschalter T2 wird fast spannungslos und somit fast verlustfrei eingeschaltet. Daraufhin beginnt in dem zweiten Halbleiterschalter T2 ein Strom I2 zu fließen, wodurch I1 abnimmt. Da der zweite Halbleiterschalter T2 in Durchlassrichtung oberhalb des Schwellenwertes I_{S} für die elektrische Stromstärke eine höhere elektrische Leitfähigkeit als der erste Halbleiterschalter T1 in Durchlassrichtung aufweist, übernimmt der zweite Halbleiterschalter T2 schnell fast den gesamten Stromfluss, so dass I1 fast auf Null sinkt, während I2 auf einen Maximalwert steigt. Zu einem Schaltzeitpunkt ts3 wird der erste Halbleiterschalter T1 abgeschaltet.

Beim Abschalten der Schaltanordnung 1 wird zunächst zu einem Schaltzeitpunkt ts4 der erste Halbleiterschalter T1 eingeschaltet. Danach wird zu einem Schaltzeitpunkt ts5 der zweite Halbleiterschalter T2 abgeschaltet. Daraufhin fällt I2 auf Null, während I1 auf einen Maximalwert steigt. Zu einem Schaltzeitpunkt ts6 wird der erste Halbleiterschalter T1 abgeschaltet. Daraufhin steigen die Spannungen U1 und U2 von Null auf einen Maximalwert, woraufhin I1 auf Null fällt.

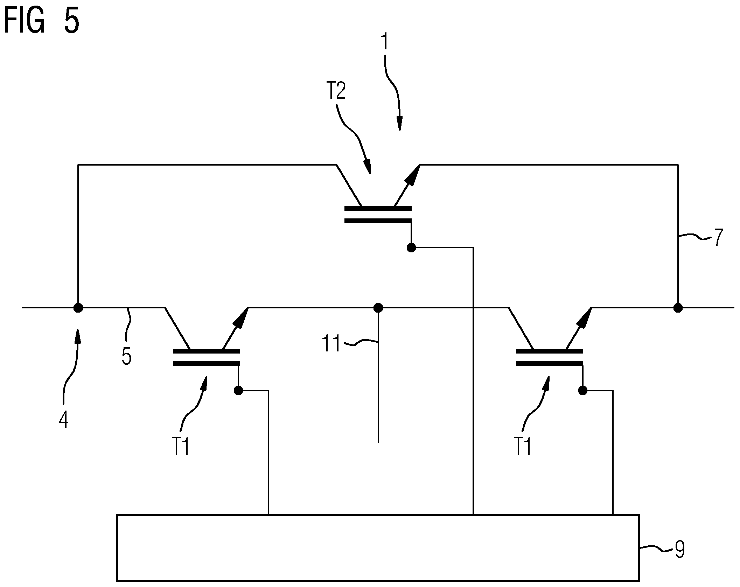

Figur 5 (FIG 5) zeigt einen Schaltplan eines dritten Ausführungsbeispiels einer erfindungsgemä-ßen Schaltanordnung 1. Die Schaltanordnung 1 umfasst eine Schalterparallelschaltung 4 eines ersten Stromzweigs 5 und eines zweiten Stromzweigs 7. Im Unterschied zu den anhand der Figuren 2 und 3 beschriebenen Ausführungsbeispielen weist der erste Stromzweig 5 zwei in Reihe geschaltete und gleich ausgebildete erste Halbleiterschalter T1 auf. Der zweite Stromzweig 7 weist wiederum einen zweiten Halbleiterschalter T2 auf. Jeder erste Halbleiterschalter T1 weist geringere Schaltverluste und eine höhere Schaltgeschwindigkeit als der zweite Halbleiterschalter T2 auf. Der zweite Halbleiterschalter T2 weist in Durchlassrichtung oberhalb eines Schwellenwertes I_{S} für die elektrische Stromstärke eine höhere elektrische Leitfähigkeit als jeder erste Halbleiterschalter T1 in Durchlassrichtung auf. Alle Halbleiterschalter T1, T2 sind durch eine Steuereinheit 9 ansteuerbar. Von der Reihenschaltung der beiden ersten Halbleiterschalter T1 zweigt ein erster Zwischenabgriff 11 ab, über den ein Strompfad aus der Reihenschaltung herausführbar ist, so dass die Schaltanordnung 1 wahlweise mit einem ersten Halbleiterschalter T1 oder mit beiden ersten Halbleiterschaltern T1 betrieben werden kann.

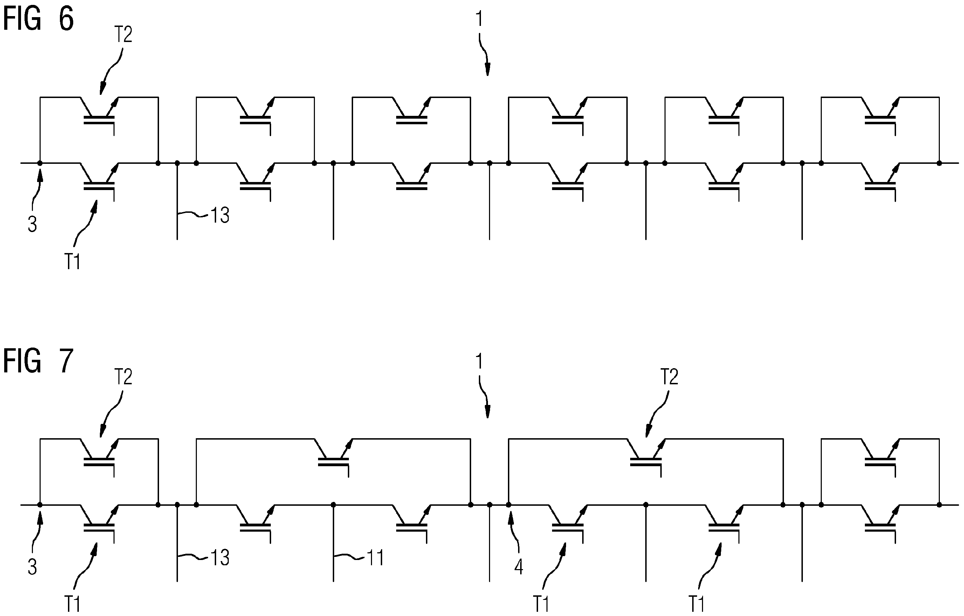

Figur 6 (FIG 6) zeigt einen Schaltplan eines vierten Ausführungsbeispiels einer erfindungsgemäßen Schaltanordnung 1. Die Schaltanordnung 1 dieses Ausführungsbeispiels umfasst sechs in Reihe geschaltete Schalterparallelschaltungen 3. Jede dieser Schalterparallelschaltungen 3 ist wie die anhand von Figur 2 beschriebene Schalterparallelschaltung 3 ausgebildet. Die Halbleiterschalter T1, T2 aller Schalterparallelschaltungen 3 sind durch eine Steuereinheit 9 ansteuerbar, die der Übersichtlichkeit halber ist in Figur 6 nicht dargestellt ist. Von der Reihenschaltung der Schalterparallelschaltungen 3 zweigt zwischen je zwei aufeinander folgenden Schalterparallelschaltungen 3 ein zweiter Zwischenabgriff 13 ab, über den ein Strompfad aus der Reihenschaltung herausführbar ist, so dass die Schaltanordnung 1 auch mit weniger als sechs Schalterparallelschaltungen 3 betrieben werden kann.

Figur 7 (FIG 7) zeigt einen Schaltplan eines fünften Ausführungsbeispiels einer erfindungsgemäßen Schaltanordnung 1. Die Schaltanordnung 1 dieses Ausführungsbeispiels umfasst vier in Reihe geschaltete Schalterparallelschaltungen 3, 4. Zwei Schalterparallelschaltungen 3 sind wie die anhand von Figur 3 beschriebene Schalterparallelschaltung 3 ausgebildet. Die anderen beiden Schalterparallelschaltungen 4 sind wie die anhand von Figur 5 beschriebene Schalterparallelschaltung 4 ausgebildet. Die Halbleiterschalter T1, T2 aller Schalterparallelschaltungen 3 sind durch eine Steuereinheit 9 ansteuerbar, die der Übersichtlichkeit halber in Figur 7 nicht dargestellt ist. Von der Reihenschaltung der Schalterparallelschaltungen 3 zweigt zwischen je zwei aufeinander folgenden Schalterparallelschaltungen 3 ein zweiter Zwischenabgriff 13 ab, über den ein Strompfad aus der Reihenschaltung herausführbar ist, so dass die Schaltanordnung 1 auch mit weniger als vier Schalterparallelschaltungen 3, 4 betrieben werden kann.

Die anhand der Figuren 6 und 7 beschriebenen Schaltanordnungen 1 können vorteilhaft für eine Realisierung eines so genannten Multilevelbetriebs verwendet werden. Dabei wird eine zeitabhängige Spannung realisiert, indem zeitabhängig geeignete Schalterparallelschaltungen 3, 4 und deren Halbleiterschaltern T1, T2 einer Schaltanordnung 1 verwendet werden, wobei die jeweils verwendeten Schalterparallelschaltungen 3, 4 in der Reihenschaltung der jeweiligen Schaltanordnung 1 aufeinander folgen.

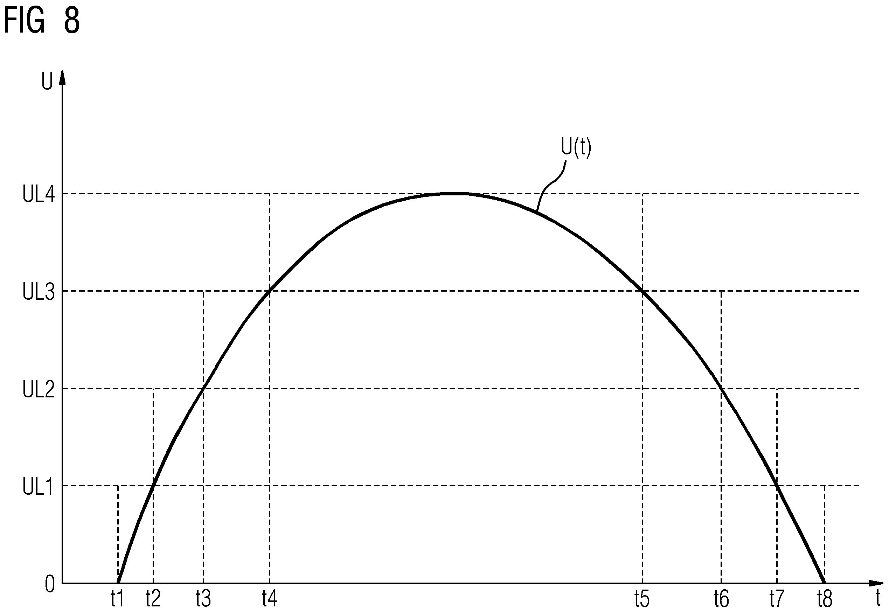

Figur 8 zeigt ein Spannungs-Zeit-Diagramm einer zu realisierenden Spannung U(t) in Abhängigkeit von der Zeit t. Die Spannung U(t) hat in diesem Fall den Verlauf einer Halbwelle einer sinusförmigen Funktion. Um die Spannung zu realisieren, werden vier äquidistante Spannungslevel UL1 bis UL4 eingeführt, wobei die Differenz zweier aufeinander folgender Spannungslevel UL1 bis UL4 gleich dem Wert eines ersten Spannungslevels UL1 ist. Die Spannung U(t) nimmt zwischen Zeitpunkten t1 und t2 und zwischen Zeitpunkten t7 und t8 Werte zwischen 0 und UL1 an, zwischen Zeitpunkten t2 und t3 und zwischen Zeitpunkten t6 und t7 Werte zwischen UL1 und UL2, zwischen Zeitpunkten t3 und t4 und zwischen Zeitpunkten t5 und t6 Werte zwischen UL2 und UL3 und zwischen Zeitpunkten t4 und t5 Werte zwischen UL3 und UL4.

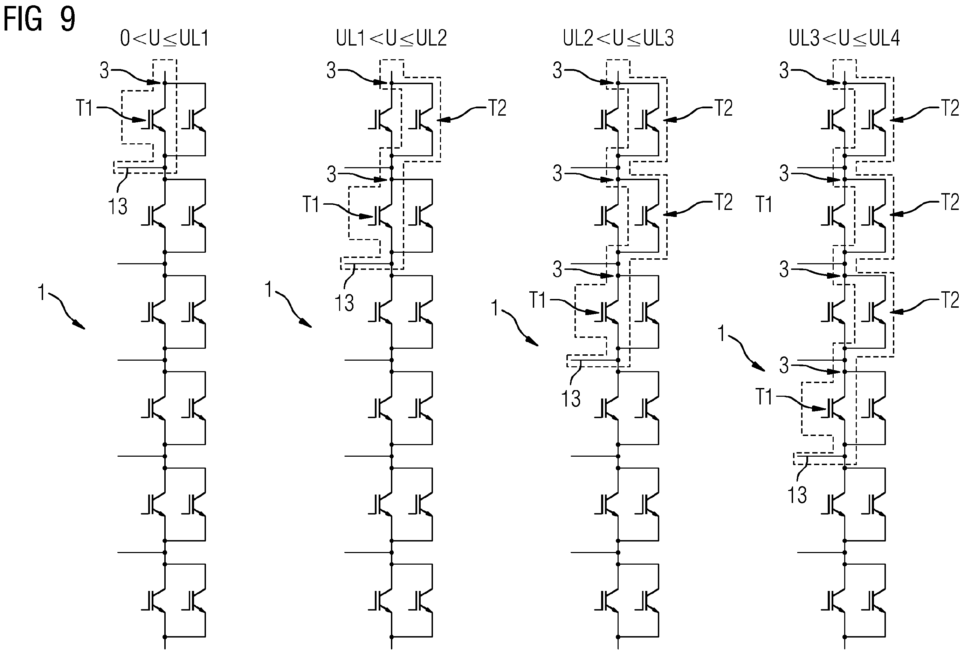

Figur 9 zeigt, wie die in Figur 8 gezeigte Spannung U(t) mit einer anhand von Figur 6 beschriebenen Schaltanordnung 1 realisiert wird. In diesem Fall wird die Differenz zweier aufeinander folgender Spannungslevel UL1 bis UL4 jeweils von einem der Halbleiterschalter T1, T2 der Schaltanordnung 1 erzeugt. Daher wächst mit wachsendem Spannungslevel UL1 bis UL4 die Anzahl der Halbleiterschalter T1, T2, die zur Erzeugung der jeweiligen Spannung verwendet werden. Figur 9 zeigt, welche Halbleiterschalter T1, T2 in jeweiligen Spannungsbereichen zwischen zwei aufeinanderfolgenden Spannungsleveln UL1 bis UL4 verwendet werden, um eine Spannung in diesem Spannungsbereich zu realisieren. Die jeweils verwendeten Halbleiterschalter T1, T2 sind in Figur 9 von einem gestrichelt gezeichneten Polygon umgeben. Außerdem umgibt dieses Polygon auch den jeweils verwendeten Zwischenabgriff 13, über den der Strompfad aus der Schaltanordnung 1 herausgeführt ist.

Spannungen U zwischen 0 und UL1 werden durch nur einen ersten Halbleiterschalter T1 einer Schalterparallelschaltung 3 realisiert, wobei der jeweilige Spannungswert als zeitlicher Mittelwert einer Modulation, beispielsweise einer Pulsweitenmodulation, der von diesem Halbleiterschalter T1 ausgegebenen Spannung erzeugt wird. Bei einer Pulsweitenmodulation der Spannung des Halbleiterschalters T1 wird der Halbleiterschalter T1 schnell aufeinander folgend einund ausgeschaltet, so dass ein zeitlicher Mittelwert der während einer Vielzahl aufeinander folgender Perioden der Pulsweitenmodulation die jeweilige Spannung U ist. Die Periodendauer der Pulsweitenmodulation ist dabei sehr klein gegenüber einer Zeitdauer, in der sich die Spannung U(t) wesentlich ändert.

Spannungen U zwischen UL1 und UL2 werden durch den zweiten Halbleiterschalter T2 einer ersten Schalterparallelschaltung 3 und den ersten Halbleiterschalter T1 einer zweiten Schalterparallelschaltung 3 realisiert. Dabei bleibt der zweite Halbleiterschalter T2 dauerhaft eingeschaltet, um die Spannung UL1 zu erzeugen, während die Spannung des ersten Halbleiterschalters T1 moduliert, beispielsweise pulsweitenmoduliert, wird, um die Differenz zwischen der zu erzeugenden Spannung U und UL1 zu erzeugen.

Spannungen U zwischen UL2 und UL3 werden durch die zweiten Halbleiterschalter T2 einer ersten Schalterparallelschaltung 3 und einer zweiten Schalterparallelschaltung 3 sowie dem ersten Halbleiterschalter T1 einer dritten Schalterparallelschaltung 3 realisiert. Dabei bleiben die beiden zweiten Halbleiterschalter T2 dauerhaft eingeschaltet, um die Spannung UL1+UL2 zu erzeugen, während die Spannung des ersten Halbleiterschalters T1 moduliert, beispielsweise pulsweitenmoduliert, wird, um die Differenz zwischen der zu erzeugenden Spannung U und UL1+UL2 zu erzeugen.

Spannungen U zwischen UL3 und UL4 werden durch die zweiten Halbleiterschalter T2 einer ersten Schalterparallelschaltung 3, einer zweiten Schalterparallelschaltung 3 und einer dritten Schalterparallelschaltung 3 sowie dem ersten Halbleiterschalter T1 einer vierten Schalterparallelschaltung 3 realisiert. Dabei bleiben die drei zweiten Halbleiterschalter T2 dauerhaft eingeschaltet, um die Spannung UL1+UL2+UL3 zu erzeugen, während die Spannung des ersten Halbleiterschalters T1 moduliert, beispielsweise pulsweitenmoduliert, wird, um die Differenz zwischen der zu erzeugenden Spannung U und UL1+UL2+UL3 zu erzeugen.

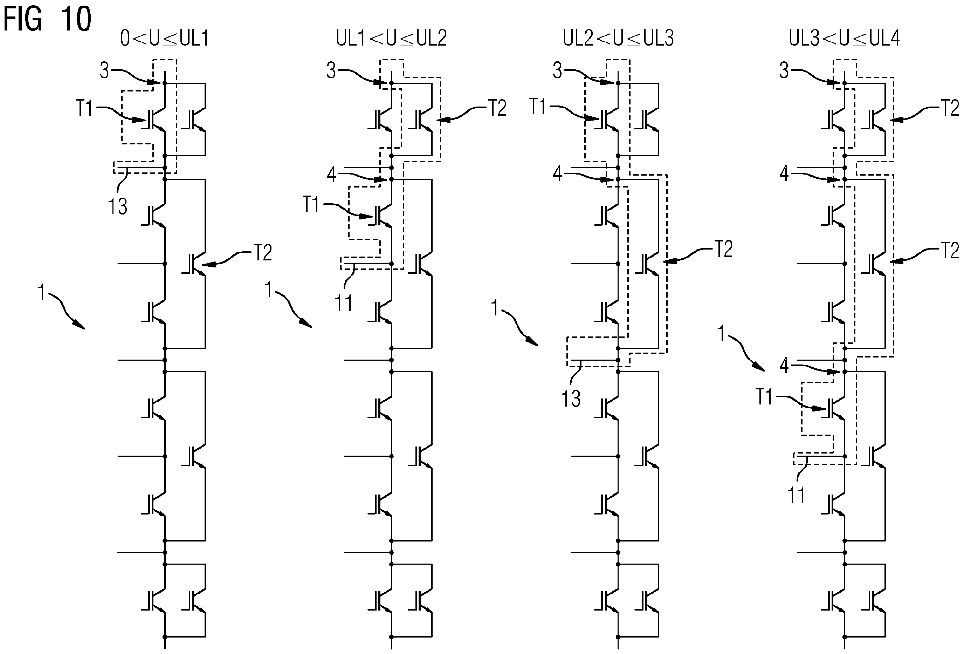

Figur 10 zeigt, wie die in Figur 8 gezeigte Spannung U(t) mit einer anhand von Figur 7 beschriebenen Schaltanordnung 1 realisiert wird.

Figur 10 zeigt analog zu Figur 9, welche Halbleiterschalter T1, T2 in jeweiligen Spannungsbereichen zwischen zwei aufeinanderfolgenden Spannungslevel UL1 bis UL4 verwendet werden, um eine Spannung in diesem Spannungsbereich zu realisieren und welche Zwischenabgriffe 11, 13 verwendet werden.

Spannungen U zwischen 0 und UL1 werden durch nur einen ersten Halbleiterschalter T1 einer Schalterparallelschaltung 3 realisiert, wobei die Spannung des ersten Halbleiterschalters T1 moduliert, beispielsweise pulsweitenmoduliert, wird, um die jeweilige Spannung U zu erzeugen.

Spannungen U zwischen UL1 und UL2 werden durch den zweiten Halbleiterschalter T2 einer Schalterparallelschaltung 3 und einen der ersten Halbleiterschalter T1 einer Schalterparallelschaltung 4 realisiert. Dabei bleibt der Halbleiterschalter T2 dauerhaft eingeschaltet, um die Spannung UL1 zu erzeugen, während die Spannung des Halbleiterschalters T1 moduliert, beispielsweise pulsweitenmoduliert, wird, um die Differenz zwischen der zu erzeugenden Spannung U und UL1 zu erzeugen.

Spannungen U zwischen UL2 und UL3 werden durch den zweiten Halbleiterschalter T2 einer Schalterparallelschaltung 4 und den ersten Halbleiterschalter T1 einer Schalterparallelschaltung 3 realisiert. Dabei bleibt der Halbleiterschalter T2 dauerhaft eingeschaltet, um die Spannung UL1+UL2 zu erzeugen, während die Spannung des Halbleiterschalters T1 moduliert, beispielsweise pulsweitenmoduliert, wird, um die Differenz zwischen der zu erzeugenden Spannung U und UL1+UL2 zu erzeugen.

Spannungen U zwischen UL3 und UL4 werden durch den zweiten Halbleiterschalter T2 einer Schalterparallelschaltung 3, den zweiten Halbleiterschalter T2 einer ersten Schalterparallelschaltung 4 und einen der ersten Halbleiterschalter T1 einer zweiten Schalterparallelschaltung 4 realisiert. Dabei bleiben die Halbleiterschalter T2 dauerhaft eingeschaltet, um die Spannung UL1+UL2+UL3 zu erzeugen, während die Spannung des Halbleiterschalters T1 moduliert, beispielsweise pulsweitenmoduliert, wird, um die Differenz zwischen der zu erzeugenden Spannung U und UL1+UL2+UL3 zu erzeugen.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines bestimmten Begriffes sind Personen mit männlicher, weiblicher oder anderer Geschlechteridentität mit umfasst.

## Patentansprüche

1. Schaltanordnung (1), umfassend
- wenigstens eine Schalterparallelschaltung (3, 4), die einen ersten Stromzweig (5) mit wenigstens einem ersten Halbleiterschalter (T1) und einen zu dem ersten Stromzweig (5) parallel geschalteten zweiten Stromzweig (7) mit wenigstens einem zweiten Halbleiterschalter (T2) aufweist, und
- eine Steuereinheit (9), die zum Ansteuern jedes ersten und jedes zweiten Halbleiterschalters (T2) eingerichtet ist, wobei
- jeder erste Halbleiterschalter (T1) geringere Schaltverluste und eine höhere Schaltgeschwindigkeit als jeder zweite Halbleiterschalter (T2) aufweist und
- jeder zweite Halbleiterschalter (T2) in Durchlassrichtung zumindest oberhalb eines Schwellenwertes (I_{S}) für eine elektrische Stromstärke (I1, I2) eine höhere elektrische Leitfähigkeit als jeder erste Halbleiterschalter (T1) in Durchlassrichtung aufweist.

2. Schaltanordnung (1) nach Anspruch 1, wobei jeder erste Halbleiterschalter (T1) ein Siliziumkarbit-MOSFET ist.

3. Schaltanordnung (1) nach Anspruch 1, wobei jeder erste Halbleiterschalter (T1) ein Galliumnitrid-MOSFET ist.

4. Schaltanordnung (1) nach Anspruch 1, wobei jeder erste Halbleiterschalter (T1) ein IGBT ist.

5. Schaltanordnung (1) nach einem der vorhergehenden Ansprüche, wobei jeder zweite Halbleiterschalter (T2) ein IGBT ist.

6. Schaltanordnung (1) nach einem der vorhergehenden Ansprüche, wobei der erste Stromzweig (5) wenigstens einer Schalterparallelschaltung (4) eine Reihenschaltung mehrerer, insbesondere zweier, erster Halbleiterschalter (T1) aufweist und von der Reihenschaltung zwischen je zwei aufeinander folgenden ersten Halbleiterschaltern (1) ein erster Zwischenabgriff (11) abzweigt, über den ein Strompfad aus der Reihenschaltung herausführbar ist.

7. Schaltanordnung (1) nach Anspruch 6, wobei die Steuereinheit (9) eingerichtet ist, den Strompfad aus einer Reihenschaltung mehrerer erster Halbleiterschalter (T1) einer Schalterparallelschaltung (4) über einen ersten Zwischenabgriff (11) in Abhängigkeit von einer geforderten Ausgangsspannung der Schalterparallelschaltung (4) herauszuführen.

8. Schaltanordnung (1) nach einem der vorhergehenden Ansprüche mit einer Reihenschaltung mehrerer Schalterparallelschaltungen (3, 4), wobei von der Reihenschaltung zwischen je zwei aufeinanderfolgenden Schalterparallelschaltungen (3, 4) ein zweiter Zwischenabgriff (13) abzweigt, über den ein Strompfad aus der Reihenschaltung herausführbar ist.

9. Schaltanordnung (1) nach Anspruch 8, wobei die Steuereinheit (9) eingerichtet ist, eine geforderte Ausgangsspannung der Schaltanordnung (1) durch Halbleiterschalter (T1, T2) einer von der Ausgangsspannung abhängigen Anzahl in Reihe geschalteter Schalterparallelschaltungen (3, 4) zu realisieren und dabei die Spannung wenigstens eines ersten Halbleiterschalters (T1) einer dieser Schalterparallelschaltungen (3, 4) zu modulieren, beispielsweise durch eine pulsweitenmodulierte Ansteuerung des ersten Halbleiterschalters (T1).

10. Verfahren zum Betreiben einer gemäß Anspruch 8 ausgebildeten Schaltanordnung (1), wobei eine geforderte Ausgangsspannung der Schaltanordnung (1) durch Halbleiterschalter (T1, T2) einer von der Ausgangsspannung abhängigen Anzahl in Reihe geschalteter Schalterparallelschaltungen (3, 4) realisiert wird, wobei die Spannung wenigstens eines ersten Halbleiterschalters (T1) einer dieser Schalterparallelschaltungen (3, 4) moduliert wird, beispielsweise durch eine pulsweitenmodulierte Ansteuerung des ersten Halbleiterschalters (T1).
